# FASCICULE DE BREVET EUROPEEN

(11) **EP 0 580 473 B1**
(45) Date de publication et mention de la délivrance du brevet: **05.02.1997**
(21) Numéro de dépôt: 93401794.8
(22) Date de dépôt: 09.07.1993
(51) Int. Cl.: H01F 38/28, G01R 15/04

(54) **Transformateur asservi d'intensité pour courants continus, alternatifs ou pulses**
Stromtransformator mit Rückkopplung für Gleichstrom, Wechselstrom oder gepulsten Strom
Current transformer with feedback for direct currents, alternative currents or pulsed currents

(30) Priorité: 15.07.1992 FR 9208718
(43) Date de publication de la demande: 26.01.1994
(73) Titulaire: ABB CONTROL Société Anonyme, F-69685 Chassieu Cédex (FR)
(72) Inventeur: Abraham, Claude, F-69003 Lyon (FR); Marciot, Denis, F-69005 Lyon (FR)
(74) Mandataire: Laget, Jean-Loup

(56) Documents cités:
- EP-A- 0 194 225
- CH-A- 495 654
- FR-A- 2 454 679

## Description

L'invention concerne un transformateur asservi d'intensité pour courants continus, alternatifs ou pulsés.

Un transformateur d'intensité de ce type comporte essentiellement un conducteur traversé par un courant primaire, un circuit magnétique entourant le conducteur, et une sonde sensible au champ magnétique et fournissant un signal électrique à un circuit électronique alimentant en courant secondaire un enroulement bobiné sur le circuit magnétique de façon à annuler le champ magnétique qui engendre le signal électrique.

Ce transformateur d'intensité permet, par la mesure du courant secondaire, de connaître la valeur du courant primaire avec une assez bonne linéarité de réponse pour les variations relativement lentes du courant primaire.

Pour loger la sonde sensible au champ magnétique, par exemple une sonde à effet Hall, on prévoit un entrefer dans le circuit magnétique. Cet entrefer entraîne une perte de couplage entre primaire et secondaire du transformateur.

Pour éviter le flux de fuite au voisinage de l'entrefer, on choisit un circuit magnétique de longueur grande par rapport à la largeur de l'entrefer. On a même proposé, dans le document EP-A 0 194 225, de placer à côté du circuit magnétique à entrefer, un circuit magnétique sans entrefer, les deux circuits magnétiques étant couplés magnétiquement par l'enroulement. Dans ce cas, les deux circuits magnétiques sont espacés l'un de l'autre pour éviter un court-circuit magnétique du flux dans l'entrefer.

Les inconvénients liés à ce type de réalisation sont nombreux et on peut noter en particulier : l'encombrement important lié à la présence du deuxième circuit magnétique sans entrefer, la difficulté de réalisation du bobinage de l'enroulement autour des deux circuits magnétiques, et la difficulté de réalisation mécanique du transformateur en raison du nombre de pièces mises en jeu et de l'obligation de respecter leurs positions relatives.

Le but de la présente invention est de proposer une réalisation simple du circuit magnétique pour transformateur d'intensité, assurant la réduction des pertes de couplage sans augmentation de l'encombrement.

L'invention a pour objet un transformateur asservi d'intensité pour courants continus, alternatifs ou pulsés, comportant un conducteur traversé par un courant primaire, un circuit magnétique entourant le conducteur, et une sonde sensible au champ magnétique et fournissant un signal électrique à un circuit électronique alimentant en courant secondaire un enroulement bobiné sur le circuit magnétique de façon à annuler le champ magnétique qui engendre le signal électrique, caractérisé en ce que le circuit magnétique présente un entrefer partiel.

Selon d'autres caractéristiques de l'invention :
- l'entrefer s'étend sur la plus grande partie de la section droite du circuit magnétique ;
- l'entrefer s'étend sur toute la largeur du circuit magnétique mais pas sur toute sa profondeur ;
- l'entrefer s'étend sur toute la profondeur du circuit magnétique mais pas sur toute sa largeur ;
- l'entrefer s'étend sur tout ou partie de la profondeur du circuit magnétique et il est bordé par un matériau magnétique de forme adaptée pour court-circuiter partiellement l'entrefer ;
- le circuit magnétique présente, au voisinage de l'entrefer, au moins une portion à section réduite.

A titre d'exemple, on a représenté au dessin annexé :

Figure 1 : un schéma simplifié d'un transformateur asservi d'intensité de type connu.

Figure 2 : une vue extérieure latérale d'un exemple de réalisation d'un circuit magnétique pour transformateur asservi d'intensité, à entrefer partiel fraisé, selon l'invention.

Figure 3 : une vue extérieure de face d'un autre exemple de réalisation d'un circuit magnétique pour transformateur asservi d'intensité, à tôles rapportées sans entrefer, selon l'invention.

Figure 4 : une vue extérieure de face d'un autre exemple de réalisation d'un circuit magnétique pour transformateur asservi d'intensité selon l'invention.

Figure 5 : une vue extérieure de face d'un autre exemple de réalisation d'un circuit magnétique pour transformateur asservi d'intensité, à entrefer partiel fraisé, selon l'invention.

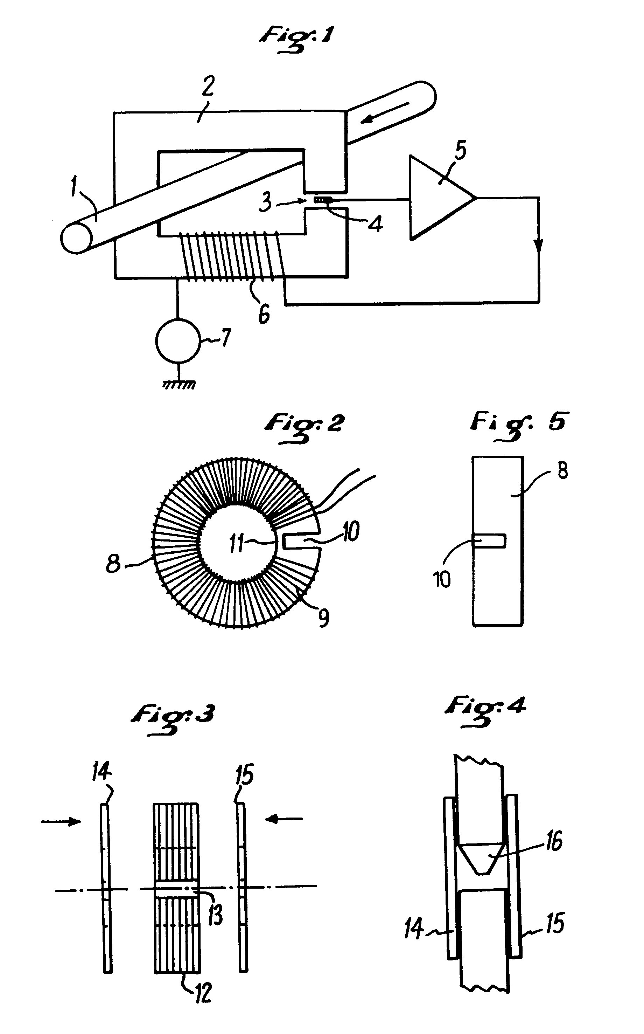

Sur la figure 1, on voit un conducteur 1 traversé par le courant primaire à mesurer. Un circuit magnétique 2 à entrefer 3 est disposé de façon à entourer le conducteur 1. Une sonde 4, sensible au champ magnétique, est disposée dans l'entrefer 3 et fournit un signal électrique à un circuit électronique 5. Le circuit 5, essentiellement constitué par un amplificateur, alimente en courant secondaire un enroulement 6 bobiné sur le circuit magnétique 2 de façon à annuler le champ magnétique qui donne naissance au signal électrique de la sonde 4. Un appareil 7 est prévu afin d'obtenir, par la mesure du courant secondaire, une mesure du courant primaire.

Sur la figure 2 est représenté un circuit magnétique 8 selon l'invention, muni de l'enroulement 9 qui joue le même rôle que l'enroulement 6 de la figure 1.

L'entrefer 10, réalisé par fraisage par exemple, n'est que partiel pour réduire les pertes de couplage entre primaire et secondaire. Cet entrefer s'étend sur la plus grande partie de la section droite du circuit magnétique 8, mais il laisse une zone de continuité 11 du circuit magnétique qui réduit le flux de fuites.

Dans le mode de réalisation de la figure 2, l'entrefer 10 s'étend sur toute la largeur du circuit magnétique, mais pas sur toute sa profondeur.

Dans le mode de réalisation de la Figure 5, l'entrefer 10 s'étend sur toute la profondeur du circuit magnétique 8 mais pas sur toute sa largeur.

Dans le mode de réalisation de la figure 3, le circuit magnétique est composé d'un empilage de tôles 12 muni d'un entrefer partiel ou total 13. Cet empilage de tôles 12 est à son tour flanqué de deux tôles rapportées 14, 15 qui ne sont pas échancrées au droit de l'entrefer et qui réduisent le flux de fuites sur les côtés de l'entrefer. Ces deux tôles sont représentées écartées de l'empilage 12 mais elles sont appliquées latéralement sur l'empilage 12.

Ces deux tôles peuvent être remplacées par tout matériau magnétique de forme adaptée pour court-circuiter partiellement l'entrefer.

On voit que la réalisation du circuit magnétique, conformément à l'invention, n'entraîne pas d'opérations complexes de fabrication. Il suffit en effet de pratiquer un fraisage moins profond (figure 2) que dans le cas habituel, et éventuellement de coller, sur un empilage de tôles fraisé, deux tôles latérales non fraisées (figure 3).

En outre, on peut remarquer que la réalisation selon l'invention, en assurant une continuité du circuit magnétique au droit de l'entrefer, et en réduisant de ce fait le flux de fuites, permet de réduire l'encombrement du transformateur asservi d'intensité.

Selon un mode de réalisation particulier de l'invention, le circuit magnétique présente, au voisinage de l'entrefer, au moins une portion à section réduite. Dans ce cas, les deux extrémités de la partie à section non réduite du circuit magnétique sont réunies par un matériau magnétique de forme adaptée qui court-circuite partiellement l'entrefer.

Un exemple de réalisation correspondante est représenté figure 4. Dans cet exemple, l'une des extrémités du circuit magnétique 2 présente une portion 16 à section réduite, et le matériau magnétique court-circuitant l'entrefer est symbolisé par deux plaques 14, 15, constituées par exemple par des paquets de tôles.

De cette manière, en cas de forte amplitude du courant primaire ou de forte variation de ce courant, la portion à section réduite du circuit magnétique se sature et le circuit magnétique présente un entrefer apparent plus grand que l'entrefer réel. Il en résulte que le transformateur d'intensité selon l'invention peut mesurer des courants primaires dans un domaine élargi, et que la linéarité de la réponse est améliorée sur l'ensemble du domaine de mesure.

Dans la description qui précède, le circuit magnétique a été représenté avec un seul entrefer. L'invention couvre également le cas d'un circuit magnétique à plusieurs entrefers, dont au moins l'un est partiel.

## Revendications

1. Transformateur asservi d'intensité pour courants continus, alternatifs ou pulsés, comportant un conducteur traversé par un courant primaire, un circuit magnétique entourant le conducteur, et une sonde sensible au champ magnétique et fournissant un signal électrique à un circuit électronique alimentant en courant secondaire un enroulement bobiné sur le circuit magnétique de façon à annuler le champ magnétique qui engendre le signal électrique, caractérisé en ce que le circuit magnétique (8) présente un entrefer (10) partiel.

2. Transformateur selon la revendication 1, caractérisé en ce que l'entrefer (10) s'étend sur la plus grande partie de la section droite du circuit magnétique (8).

3. Transformateur selon la revendication 1, caractérisé en ce que l'entrefer (10) s'étend sur toute la largeur du circuit magnétique (8) mais pas sur toute sa profondeur.

4. Transformateur selon la revendication 1, caractérisé en ce que l'entrefer (10) s'étend sur toute la profondeur du circuit magnétique (8) mais pas sur toute sa largeur.

5. Transformateur selon la revendication 1, caractérisé en ce que l'entrefer (10) s'étend sur tout ou partie de la profondeur du circuit magnétique (8) et il est bordé latéralement par une ou plusieurs tôles (14, 15) ne présentant pas d'entrefer (10).

6. Transformateur selon la revendication 1, caractérisé en ce que l'entrefer (10) est partiellement court-circuité par un matériau magnétique de forme adaptée.

7. Transformateur selon la revendication 6 caractérisé en ce que le circuit magnétique (2) présente, au voisinage de l'entrefer, au moins une portion (11) à section réduite.

## Patentansprüche

1. Rückgekoppelter Stromtransformator für Gleichstrom, Wechselstrom oder pulsierenden Strom mit einem von Primärstrom durchflossenen Leiter, einem den Leiter umgebenden magnetischen Kreis, und einer Sonde, die ein Magnetfeld fühlen kann und ein elektrisches Signal an eine elektronische Schaltung liefert, welche eine auf einen magnetischen Kreis gewickelte Wicklung mit Sekundärstrom versorgt, derart daß er das magnetische Feld, welches das elektrische Signal hervorbringt, zum Verschwinden bringt **dadurch gekennzeichnet**, daß
der magnetische Kreis (8) einen partiellen Luftspalt aufweist.

2. Transformator nach Anspruch 1, dadurch gekennzeichnet, daß der Luftspalt (10) sich über den größten Teil des Querschnitts des magnetischen Kreises (8) erstreckt.

3. Transformator nach Anspruch 1, dadurch gekennzeichnet, daß der Luftspalt (10) sich über die ganze Breite des magnetischen Kreises (8), aber nicht über seine ganze Tiefe erstreckt.

4. Transformator nach Anspruch 1, dadurch gekennzeichnet, daß der Luftspalt (10) sich über die ganze Tiefe des magnetischen Kreises (8), aber nicht über seine ganze Breite erstreckt.

5. Transformator nach Anspruch 1, dadurch gekennzeichnet, daß der Luftspalt (10) sich über die ganze oder einen Teil der Tiefe des magnetischen Kreises (8) erstreckt und seitlich durch eine oder mehrere Bleche (14, 15) begrenzt ist, die keinen Luftspalt (10) aufweisen.

6. Transformator nach Anspruch 1, dadurch gekennzeichnet, daß der Luftspalt (10) durch ein magnetisches Material geeigneter Form teilweise kurzgeschlossen ist.

7. Transformator nach Anspruch 6, dadurch gekennzeichnet, daß der magnetische Kreis (2) in der Nachbarschaft des Magnetspalts mindestens einem Abschnitt (11) verringerten Querschnitts aufweist.

## Claims

1. A current transformer with feedback for continuous, alternating or pulsed currents, comprising a conductor through which a primary current passes, a magnetic circuit surrounding the conductor, and a probe sensitive to the magnetic field and providing an electrical signal to an electronic circuit supplying with secondary current a winding wound on the magnetic circuit so as to cancel out the magnetic field which generates the electrical signal, characterised in that the magnetic circuit (8) has a partial air gap (10).

2. A transformer according to Claim 1, characterised in that the air gap (10) extends over the major part of the cross-section of the magnetic circuit (8).

3. A transformer according to Claim 1, characterised in that the air gap (10) extends over the entire width of the magnetic circuit (8), but not over its entire depth.

4. A transformer according to Claim 1, characterised in that the air gap (10) extends over the entire depth of the magnetic circuit (8), but not over its entire width.

5. A transformer according to Claim 1, characterised in that the air gap (10) extends over all or part of the depth of the magnetic circuit (8) and is bordered laterally by one or more plates (14, 15) which do not have an air gap (10).

6. A transformer according to Claim 1, characterised in that the air gap (10) is partly short-circuited by a magnetic material of suitable form.

7. A transformer according to Claim 6, characterised in that the magnetic circuit (2) has at least one portion (11) of reduced section in the vicinity of the air gap.
